# EUROPEAN PATENT APPLICATION

(11) **EP 3 667 712 A1**
(43) Date of publication of application: **17.06.2020**
(21) Application number: 18211809.1
(22) Date of filing: 12.12.2018
(51) Int. Cl.: H01L 21/768, H01L 27/115

(54) **IMPROVED ROUTING CONTACTS FOR 3D MEMORY**

(71) Applicant: IMEC vzw, 3001 Leuven (BE)
(72) Inventor: Lavizarri, Simone, 3001 Leuven (BE); Di Piazza, Luca, 3001 Leuven (BE)
(74) Representative: Nederlandsch Octrooibureau

(57) **Abstract**

The present disclosure relates to a multilayer device comprising an electrically insulating bottom layer provided on a semiconductor substrate; a contact region comprising a plurality of stacked horizontal layers provided on the bottom layer, wherein the horizontal layers are substantially parallel to a surface of the semiconductor substrate, wherein the horizontal layers comprise a plurality of alternating electrically conductive layers and a plurality of electrically insulating layers, wherein each respective one of the electrically insulating layers is provided on a respective one of said electrically conductive layers, wherein the horizontal layers form a stepped surface in the contact region defining a staircase extending between said stepped surface and said bottom layer; a plurality of contact openings; and a plurality of electrically conductive interconnects, wherein each respective one of said interconnects is provided in a respective one of the plurality of contact openings.

## Description

### Field of the disclosure

The present disclosure relates to routing contacts for 3D memory.

### Background art

Multidimensional memory-based systems and methods of fabrication thereof, are known. Integrated circuits tend to be limited to high volume production chips addressing factors such as size, increased storage capacity, cost-effective fabrication and device performance. Memory systems are known to have circuit components comprising the memory array and the logic circuit. Two-dimensional (2D) systems are configured such that the logic circuit is positioned in the same plane as the memory array, using a larger area of the chip than is required. Common three-dimensional (3D) device architectures use a semiconductor substrate on which stacks comprising alternating conductor and insulator layers are configured vertically and a cell string is formed by filling the memory hole with appropriate materials.

Prior art provides multidimensional memory devices and methods thereof, which aim to address factors such as smaller size, power efficiency, reduced latency, increased storage capacity and cost. Additionally, devices addressing substantial capacitive loading and methods of fabrication thereof, have been previously disclosed.

US 2013/0313627 discloses a method of making multi-level contacts. The method includes providing an in-process multilevel device including at least one device region and at least one contact region. The contact region includes a plurality of electrically conductive layers configured in a step pattern. The method also includes etching a plurality of contact openings through several layers toward the plurality of electrically conductive layers.

A problem with the device disclosed in US 2013/0313627 is that it lacks compactness.

### Summary of the disclosure

It is an aim of the disclosure to provide a multilayer memory-based array device and an improved method for line routing contacts in array-based memory, allowing for more compactness.

In a first aspect, the disclosure provides a multilayer device comprising
- an electrically insulating bottom layer provided on a semiconductor substrate;
- a contact region comprising a plurality of stacked horizontal layers provided on the bottom layer, wherein the horizontal layers are substantially parallel to a surface of the semiconductor substrate, wherein the horizontal layers comprise a plurality of alternating electrically conductive layers and a plurality of electrically insulating layers, wherein each respective one of the electrically insulating layers is provided on a respective one of said electrically conductive layers, wherein the horizontal layers form a stepped surface in the contact region defining a staircase extending between said stepped surface and said bottom layer;
- a plurality of contact openings; and
- a plurality of electrically conductive interconnects, wherein each respective one of said interconnects is provided in a respective one of the plurality of contact openings, and said each respective one of said interconnects is in electrical contact with a respective one of the electrically conductive layers;
wherein said bottom layer comprises a plurality of bottom contacts; wherein said each respective one of said contact openings and said each respective one of said interconnects extend within said staircase between the respective one of said electrically conductive layers and a respective one of said bottom contacts, and wherein said each respective one of said interconnects is insulated from conductive layers below the respective one of said electrically conductive layers, wherein said being insulated is preferably realized with an insulating liner comprising a dielectric preferably comprising an oxide, a nitride, or an oxynitride.

Such a multilayer device provides improved line routing thereby reducing the total area utilised and achieving a more compact device configuration. The disclosure allows to realize the contact area and routing as much as possible under the array, allowing area saving. The staircase geometry is an efficient way to contact each electrically conductive layer and the present disclosure provides an efficient way to reuse this geometry to save area. Additional advantages of the multilayer device may include reduced latency in view of the reduced line length, an increased storage capacity as a result of the ability to combine at least two multilayer devices and a reduced area afforded by improved line routing. This may be particularly beneficial in a circuit under the array layout, preferably a CMOS under the array layout, where the devices according to the present disclosure may allow a reduction in the length and volume of the related chip and overall device, leading to increased compactness. By avoiding the routing to be done all around the memory, the line length is significantly reduced. A reduced line length, in its turn, may result in reduced latency for the signal propagating over the line. Overall, the quantity of metal may be reduced. By allowing more compactness, the present disclosure may contribute to further scaling of the multilayer device, allowing, e.g., an increase in the number of layers and/or semiconductor devices stacked above each other.

In embodiments according to the present disclosure, the device comprises at least one 3D memory semiconductor device, for instance 32, or more than 32. For such a device, line routing may relate to routing within an array of rows corresponding to wordlines (WLs) and columns corresponding to bitlines (BLs). As the number of devices increases, the routing is increasingly area consuming, hindering device scaling. This problem may be effectively mitigated by the present disclosure.

In a second aspect, the disclosure offers a system comprising
- the multilayer device according to embodiments of the present disclosure;
- a control logic module, preferably a CMOS-comprising control logic module, connected to said at least one semiconductor device;
wherein the control logic module is stacked under said multilayer device in a circuitry under the array configuration, preferably in a CMOS under the array configuration.

In a third aspect, the disclosure provides a stack of a first and a second multilayer device, wherein at least the first multilayer device is the multilayer device of the present disclosure. Since the top surface of the multilayer devices according to the present disclosure need not comprise electrical contacts, it is possible to stack a further multilayer device on top of a first multilayer device, the latter being a multilayer device according to embodiments of the present disclosure. The further multilayer device may be different from the first multilayer device. In particular, the further multilayer device may have an electrically insulating bottom layer without any bottom contacts, and instead comprise electrical top contacts provided at its top surface (like in prior art multilayer devices). Such a stack of a first multilayer device with contacts via its bottom side as disclosed herein and a further multilayer device with contacts via its top side may result in a stack of double height for the same area compared to prior art.

In a fourth aspect, the present disclosure advantageously allows a method of making multilayer interconnects comprising the steps of:
- providing a multilayer device comprising
   ∘ an electrically insulating bottom layer provided on a semiconductor substrate, the bottom layer comprising a plurality of bottom contacts;
   ∘ at least one contact region, the contact region comprising a plurality of stacked horizontal layers provided on the bottom layer, wherein the horizontal layers are substantially parallel to a surface of the semiconductor substrate, wherein the horizontal layers comprise a plurality of alternating electrically conductive layers and a plurality of electrically insulating layers, wherein each respective one of the electrically insulating layers is provided on a respective one of said electrically conductive layers, wherein the horizontal layers form a stepped surface in the contact region defining a staircase extending between said stepped surface and said bottom layer;
- etching a plurality of contact openings through the plurality of electrically conductive layers in the contact region down to the plurality of bottom contacts;
- depositing an insulating liner comprising a dielectric over at least a sidewall of the contact openings extending within said staircase;
- etching a liner top recess to the insulating liner, said etching comprising, for each respective one of said contact openings, anisotropically etching portions of said insulating liner from a distal end of the respective contact opening toward the respective one of said bottom contacts with a first etch chemistry preferably being a dry-etch chemistry, wherein said liner top recess is such that at least the respective one of said electrically conductive layers is exposed; and
- forming a plurality of interconnects within said contact openings for providing an electrical contact between a respective one of the electrically conductive layers and a respective one of the bottom contacts by means of a respective one of said interconnects.

By depositing and etching the insulating liner and subsequently forming the interconnects, a practical and effective method is provided which is not suggested by the prior art.

### Brief description of the drawings

The present disclosure will be discussed in more detail below, with reference to the attached drawings.
Fig. 1 shows a cross-section of an example embodiment of a multilayer device (1) according to the present disclosure.
Fig. 2 shows a cross-section of an example second multilayer device (101) which may be used in a stack according to the present disclosure.
Fig. 3A shows an example device cross-section relating to a step (910, 920) of the method according to the present disclosure.
Fig. 3B shows an example device top-view relating to a step (910, 920) of the method according to the present disclosure.
Fig. 4A shows an example device cross-section relating to a step (930) of the method according to the present disclosure.
Fig. 4B shows an example top-view relating to a step (930) of the method according to the present disclosure.
Fig. 5A shows an example device cross-section relating to a step (940) of the method according to the present disclosure.
Fig. 5B shows an example device top-view relating to a step (940) of the method according to the present disclosure.
Fig. 6A shows an example device cross-section relating to a step (950) of the method according to the present disclosure.
Fig. 6B shows an example device top-view relating to a step (950) of the method according to the present disclosure.
Fig. 7A shows an example device cross-section relating to a step (960) of the method according to the present disclosure.
Fig. 7B shows an example device top-view relating to a step (960) of the method according to the present disclosure.
Fig. 8A shows an example device cross-section relating to a step (970) of the method according to the present disclosure.
Fig. 8B shows an example device top-view relating to a step (970) of the method according to the present disclosure.
Fig. 9 shows an example stack (111) according to the present disclosure.

### Description of embodiments

The present disclosure will be described with respect to particular embodiments and with reference to certain drawings but the disclosure is not limited thereto but only by the claims. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the disclosure.

Furthermore, the terms first, second, third and the like in the description and in the claims, are used for distinguishing between similar elements and not necessarily for describing a sequential or chronological order. The terms are interchangeable under appropriate circumstances and the embodiments of the disclosure can operate in other sequences than described or illustrated herein.

Moreover, the terms top, bottom, over, under and the like in the description and the claims are used for descriptive purposes and not necessarily for describing relative positions. The terms so used are interchangeable under appropriate circumstances and the embodiments described herein can operate in other orientations than described or illustrated herein.

Furthermore, the various embodiments, although referred to as "preferred" are to be construed as exemplary manners in which the disclosure may be implemented rather than as limiting the scope of the disclosure.

In this document, a stacked configuration may refer to a second multilayer device stacked upon a first multilayer device.

In this document, a contact opening of either of the first or second multilayer device may have a proximal end and a distal end, wherein the distal end is the one of said proximal and said distal end furthest removed from the bottom layer.

In this document, the bottom contacts provided in the bottom layer may be interrupted, i.e. the bottom contacts are not in electrical contact with one another.

The term "comprising", used in the claims, should not be interpreted as being restricted to the elements or steps listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising A and B" should not be limited to devices consisting only of components A and B, rather with respect to the present disclosure, the only enumerated components of the device are A and B, and further the claim should be interpreted as including equivalents of those components.

In embodiments according to the present disclosure, the substrate may be any semiconducting substrate known in the art, such as monocrystalline silicon, IV-IV compounds such as silicon-germanium or silicon-germanium-carbon, III-V compounds, II-VI compounds, epitaxial layers over such substrates, or any other semiconducting or non-semiconducting material, such as silicon oxide, glass, plastic, metal or ceramic substrate. The substrate may include integrated circuits fabricated thereon, such as driver circuits for a memory device.

The multilayer device according to the present disclosure preferably comprises more than 16 electrically conductive layers, more preferably more than 32 layers, even more preferably more than 48, 64, 96 or 128 layers, for instance 64, 96 or 128 layers.

In embodiments according to the present disclosure, the electrically insulating bottom layer comprises a first dielectric and the plurality of electrically insulating layers comprise a second dielectric which may or may not be the same as the first dielectric.

In embodiments according to the present disclosure, each pair of successive electrically conductive layers of the plurality of electrically conductive layers comprises at least a first conductive layer and a second conductive layer located higher than the first conductive layer; wherein the first conductive layer comprises a first portion which laterally extends past the second conductive layer to form at least a portion of said stepped surface; and wherein the respective one of said interconnects of the second conductive layer has a greater length than the respective interconnect of the first conductive layer. In example embodiments wherein said plurality of electrically conductive layers comprises an essentially uniform thickness D1 and said plurality of insulating layers comprises an essentially uniform thickness D2, the length difference between the respective interconnect of the first and the second conductive layer is essentially equal to the sum of D1 and D2.

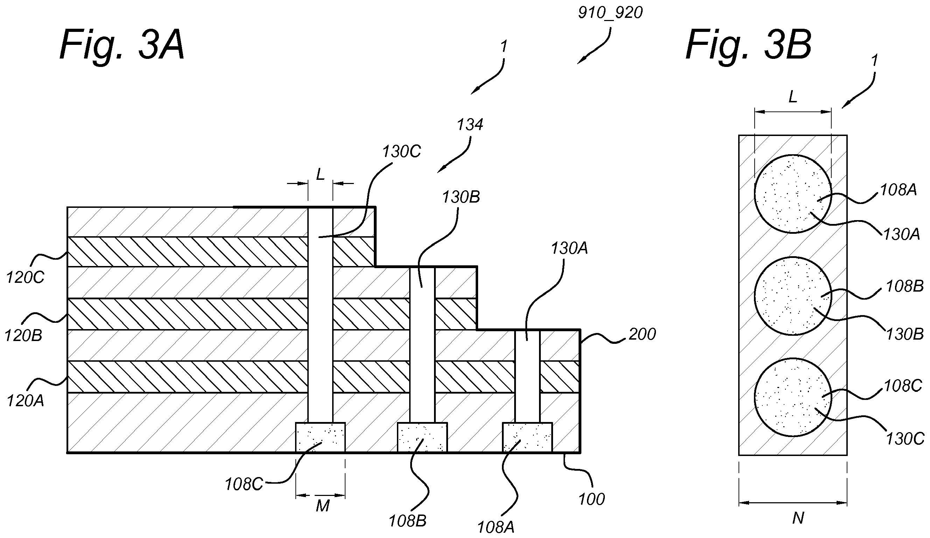

In embodiments according to the present disclosure, each respective one of said bottom contacts comprises a bottom contact lateral dimension M larger than an opening lateral dimension L. The bottom contact having a larger dimension than the contact opening, affords a more facile and cost-effective method of fabrication, whereby the value of L need not be matched exactly to a predetermined value M, but rather may be chosen equal to some value smaller than M. Related, in view of L and M not being strictly matched, there may be more tolerance with respect to uniformity of the value of M across different bottom contacts and/or with respect to uniformity of the value of L across different contact openings. Furthermore, contact openings should exhibit sufficient interspacing, and hence, the dimension M remains sufficiently below the critical dimension N, abbreviated CD, preferably wordline CD, characteristic of this spacing, see, e.g., Fig. 3B-8B.

In embodiments according to the present disclosure, the device further comprises an electrically insulating planarization layer extending over said stepped surface and comprising a top surface which is preferably essentially planar. Said planarization layer affords additional operational safety and ease of handling.

In embodiments according to the present disclosure, the device further comprises a device region comprising at least one semiconductor device connected to at least one of said electrically conductive contacts, said at least one semiconductor device comprising at least one of three-dimensional NAND, 3D NAND, storage-class memory, SCM, resistive random access memory, RRAM, phase change random access memory, PC RAM, more preferably 3D NAND and/or SCM.

In embodiments according to the present disclosure, the device comprises a high number of semiconductor devices for instance equal to 32 or larger than 32.

In embodiments according to the present disclosure, the second multilayer device comprises
- a bottom layer;
- a contact region a plurality of stacked horizontal layers provided between the bottom layer and the top surface, wherein the horizontal layers are substantially parallel to the bottom layer, wherein the horizontal layers comprise a plurality of alternating electrically conductive layers and a plurality of electrically insulating layers, wherein each respective one of the electrically insulating layers is provided on a respective one of said electrically conductive layers, wherein the horizontal layers form a stepped surface in the contact region;
- a planarization layer extending over said stepped surface and comprising a top surface comprising a plurality of top contacts;
- a plurality of contact openings extending within said planarization layer between a respective one of said electrically conductive layers and a respective one of said top contacts;
- a plurality of electrically conductive interconnects, wherein each respective one of said interconnects is provided in a respective one of the plurality of contact openings is in electrical contact with a respective one of the plurality of electrically conductive layers.

The second multilayer device may be stacked upon a first multilayer device affording an increase in storage capacity. Particularly, this second multilayer device, having no bottom contacts in its bottom layer, may be advantageously stacked upon the first device, which in accordance with the present disclosure, may have no electrical connections running in its planarization layer or through its top surface.

The method according to the present disclosure provides a facile and cost-effective approach to the forming of said plurality of interconnects. Due to the stepped surface, the anisotropic etching of the liner top recess may be done in a single step for several or even all contact openings, which would not be possible without the staircase. This advantage is particularly pronounced for embodiments wherein said plurality of electrically conductive layers comprises an essentially uniform thickness D1 and said plurality of insulating layers comprises an essentially uniform thickness D2, whereby D2 may or may not be different from D1, since in those cases, an essentially equal etch is required for each contact opening. Hereby, the etch may preferably be provided according to a time-based process, an endpoint-based process, or any combination thereof. For an etch according to a time-based process, the time during which the device is exposed to etch chemistry is measured, and the process is stopped after some pre-determined time duration. For an endpoint-based process, a concentration of a by-product produced during exposure of the device to etch chemistry is measured, and the process is stopped when a predetermined concentration threshold is exceeded.

In embodiments according to the present disclosure, said liner top recess extends from said distal end of the respective contact opening toward the respective one of said bottom contacts over a depth E essentially equal for all contact openings. This is preferably combined with an embodiment wherein said plurality of electrically conductive layers comprises an essentially uniform thickness D1 and said plurality of insulating layers comprises an essentially uniform thickness D2, whereby D2 may or may not be different from D1. In such embodiments, given the essentially uniform thickness, exposing the respective one of the electrically conductive layers conveniently relates to etching the liner top recess for essentially the same depth E for all contact openings. This may advantageously allow performing said step of liner top recess etching jointly for at least two contact openings.

In embodiments according to the present disclosure, a respective one of a plurality of electrically insulating layers is located over the respective one of the electrically conductive layers; wherein the plurality of electrically conductive layers comprise an essentially equal thickness D1; wherein the plurality of electrically insulating layers comprise an essentially equal thickness D2; and wherein said depth E is not smaller than D1 + D2 and not larger than D1+2*D2. This reproducibility of the device is enhanced by the conductive and insulating layers having an essentially equal thickness, respectively. The depth of E being given a tolerance, allows for some freedom in the etching process with respect to process parameters.

In embodiments according to the present disclosure, a respective one of a plurality of electrically insulating layers is located over the respective one of the electrically conductive layers; wherein there is not a uniform thickness of all the layers and hence a first region with a first thickness is locally etched, followed by a second region with a second thickness being locally etched.

In embodiments according to the present disclosure, said step of depositing the insulating liner further comprises depositing the insulating liner over at least the bottom contacts being metal contacts, and said step of forming the plurality of interconnects comprises a liner etch back step comprising using a second etch chemistry being selective on metal for exposing said bottom contacts, said liner etch back step preferably either preceding or being combined with said etching of said liner top recess.

In embodiments according to the present disclosure, said step of forming the plurality of interconnects comprises a metallization step comprising forming a metal fill within said plurality of contact openings and over said stepped surface; and a metal recess step comprising using a third etch chemistry preferably being a wet-etch chemistry for removing said metal fill at least from said stepped surface. This provides a simple approach to connecting the interconnects with their respective layers while preventing the interconnects from being electrically connected to each other via the stepped surface, which would be undesirable.

In embodiments according to the present disclosure, said being insulated is realized with an insulating liner comprising a dielectric preferably comprising an oxide, a nitride or an oxynitride. In embodiments, this may be an oxide, preferably silicon oxide. In other embodiments, this may be a nitride, preferably silicon nitride, or an oxynitride, preferably silicon oxynitride. Such materials provide an advantageous choice since they may allow for a high breakdown voltage for the resulting insulating liner, suitable for many applications including NAND devices. For applications such as storage-class memory involving lower voltage, the dielectric for the insulating liner may be either of an oxide, a nitride, an oxynitride, or alumina.

In embodiments according to the present disclosure, the multilayer device comprises a device region comprising at least one semiconductor device connected to at least one of said electrically conductive contacts, said at least one semiconductor device comprising at least one of three-dimensional NAND, 3D NAND, storage-class memory, SCM, resistive random access memory, RRAM, phase change random access memory, PC RAM. In embodiments, the at least one semiconductor device comprises magnetic random access memory, MRAM, and conducting bridge random access memory, CB RAM.

In a further aspect, the present disclosure provides a system comprising
- the multilayer device according to the present disclosure;
- a control logic module, preferably a CMOS-comprising control logic module, connected to said at least one semiconductor device;
wherein the control logic module is stacked under said multilayer device in a circuitry under the array configuration, preferably in a CMOS under the array configuration. In view of the interconnects extending within said staircase, the total path length required to make an electrical contact between the conductive layers and the control logic module may be reduced whenever at least some, preferably all, of the control logic module is under the array.

In a further aspect, the present disclosure provides a method of making multilayer interconnects comprising the steps of:
- providing a multilayer device comprising
   ∘ at least one contact region, the contact region comprising a plurality of electrically conductive layers configured according to a stepped surface;
   ∘ a bottom layer comprising a plurality of bottom contacts;
- etching a plurality of contact openings through the plurality of electrically conductive layers in the contact region to the plurality of bottom contacts;
- depositing an insulating liner comprising a dielectric over at least a sidewall of the contact openings extending within said staircase;
- etching a liner top recess to the insulating liner, said etching comprising, for each respective one of said contact openings, anisotropically etching portions of said insulating liner from a distal end of the respective contact opening toward the respective one of said bottom contacts with a first etch chemistry preferably being a dry-etch chemistry, wherein said liner top recess is such that at least the respective one of said electrically conductive layers is exposed; and
- forming a plurality of interconnects within said contact openings for providing an electrical contact between a respective one of the electrically conductive layers and a respective one of the bottom contacts by means of a respective one of said interconnects.

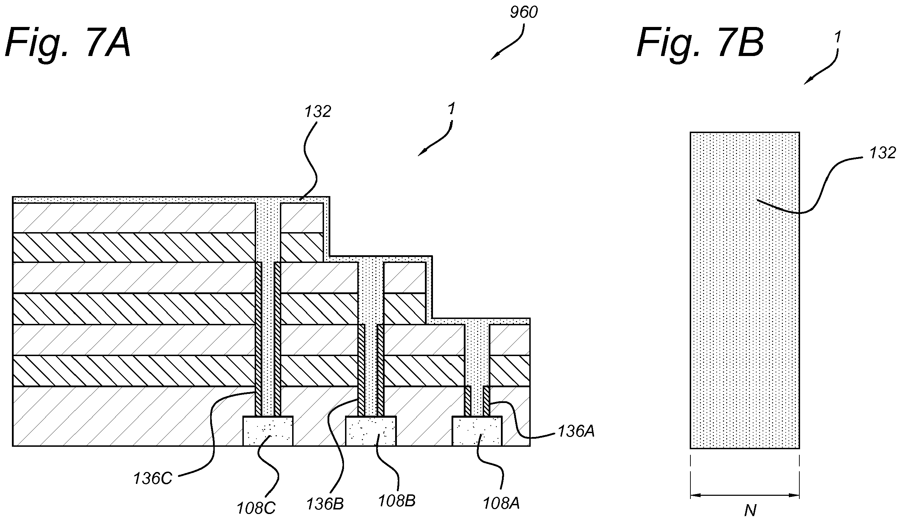

In embodiments according to the present disclosure, the etching of the liner top recess may for instance relate to an anisotropic etch 152 as shown in Fig. 7A. In preferred embodiments, said liner top recess extends from said distal end of the respective contact opening toward the respective one of said bottom contacts over a depth E essentially equal for all contact openings, and said step of liner top recess etching is performed jointly for at least two contact openings, preferably at least three contact openings, more preferably more than three contact openings. This is preferably combined with an embodiment wherein said plurality of electrically conductive layers comprises an essentially uniform thickness D1 and said plurality of insulating layers comprises an essentially uniform thickness D2, whereby D2 may or may not be different from D1. In such embodiments, given the essentially uniform thickness, exposing the respective one of the electrically conductive layers conveniently relates to etching the liner top recess for essentially the same depth E for all contact openings. This joint etching may facilitate and enhance the speed of manufacturing and is possible also owing to the anisotropic nature of the etching chemistry, as well as the staircase geometry.

In embodiments according to the disclosure, the liner is deposited conformally along the sidewall of the contact opening, i.e. it is deposited with substantially uniform thickness. This may for example be done using atomic layer deposition. In embodiments according to the present disclosure, the insulating liner is deposited on the device as a whole, including several portions other than the sidewalls of the contact openings, such as the stepped surface and top portions of the bottom contacts. These liner portions may be etched back in a step for exposing the metal contacts, wherein the etch is selective on metal, removing the liner from the top portions of the bottom contacts, and, if present, also removing it from the stepped surface. In embodiments, said etching of the liner top recess may be a continuation of the etch that is required for said exposing of the metal contacts, which means that the etch may go on without interruption.

Preferably, the etch used for the liner top recess, and, optionally, also the step of exposing off the metal contacts, is a very anisotropic etch, preferably according to a high-power dry-etch process. In embodiments according to the present disclosure with uniform layer thicknesses, the top liner to be removed may be essentially the same for different contacts despite the length of the interconnects not being the same.

In the step of depositing the insulating liner on the sidewall of the contact opening, the depositing may be adapted for high conformality. This may be attained, for instance, with atomic layer deposition. The liner thickness may be chosen sufficiently large so that it is compatible with the maximum applied voltage. Particularly, the thickness may be chosen so that the electrical field across the liner is lower than the breakdown field. On the other hand, the liner thickness may be chosen sufficiently small so as to allow sufficient diameter for the interconnects, which are subject to some minimal value which may be referred to as contact critical dimension, contact CD.

The sidewall of the contact opening extending within said staircase may for instance be essentially cylindrical, and is preferably essentially uniform in shape and diameter across contact openings.

In embodiments according to the present disclosure, said multilayer device is obtained starting by forming a metal layer on the semiconductor substrate patterned according to the plurality of bottom contacts. This may relate to patterning of the bottom layer.

In example embodiments, a plurality of alternating layers of sacrificial nitride and a dielectric are formed upon the bottom layer, the nitride is replaced by metal gate through appropriate processing and the contact openings are formed with an etch stop on metal, obtaining the multilayer device, wherein the dielectric, preferably oxide, corresponds to the bottom layer and the electrically insulating layers, and the metal replacing the nitride corresponds to the electrically conductive layers. In other example embodiments, polysilicon instead of nitride is used as sacrificial material to be replaced by metal gate.

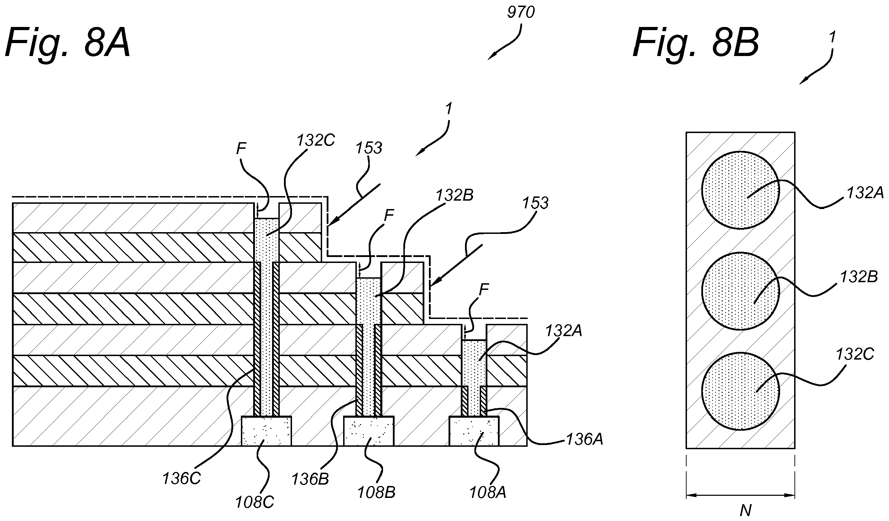

In embodiments according to the present disclosure, said step of forming the plurality of interconnects comprises a metallization step comprising forming a metal fill within said plurality of contact openings and over said stepped surface; and a metal recess step comprising using a third etch chemistry preferably being a wet-etch chemistry for removing said metal fill at least from said stepped surface. In the metal recess step, it is crucial to remove metal from the sides of the staircase to prevent any electrical connection between interconnects via the stepped surface. This may relate to an etch 153 as shown in Fig. 8A. In embodiments, the metallization step relates to an atomic layer deposition (ALD) process, as such a process advantageously allows the final thickness of the film on the stepped surface to be of essentially uniform thickness across the device. This has the advantage that the metal recess step can be performed more accurately, allowing to ensure that metal is removed from the entire stepped surface. In a more preferred embodiment, said metal recess step comprises forming a metal recess extending from said distal end of the respective contact opening toward the respective one of said bottom contacts over a depth F essentially equal for all contact openings, and wherein preferably said step of liner top recess etching is performed jointly for at least two contact openings. In a related embodiment, a respective one of a plurality of electrically insulating layers is located over the respective one of the electrically conductive layers; wherein the plurality of electrically conductive layers comprise an essentially equal thickness D1; wherein the plurality of electrically insulating layers comprise an essentially equal thickness D2; and wherein said depth F is larger than zero and smaller than D2, preferably equalling about D2/2.

In embodiments according to the present disclosure, the planarization layer is a dielectric that is preferably provided in a planarization step following said metal recess step, wherein said planarization step comprises forming the planarization layer over said stepped surface. This may comprise additional processing of said planarization layer to obtain an essentially planar top surface for said planarization layer.

Below are examples of the present disclosure which should not be interpreted as limiting the disclosure in any way.

### Example 1: A Multilayer Device

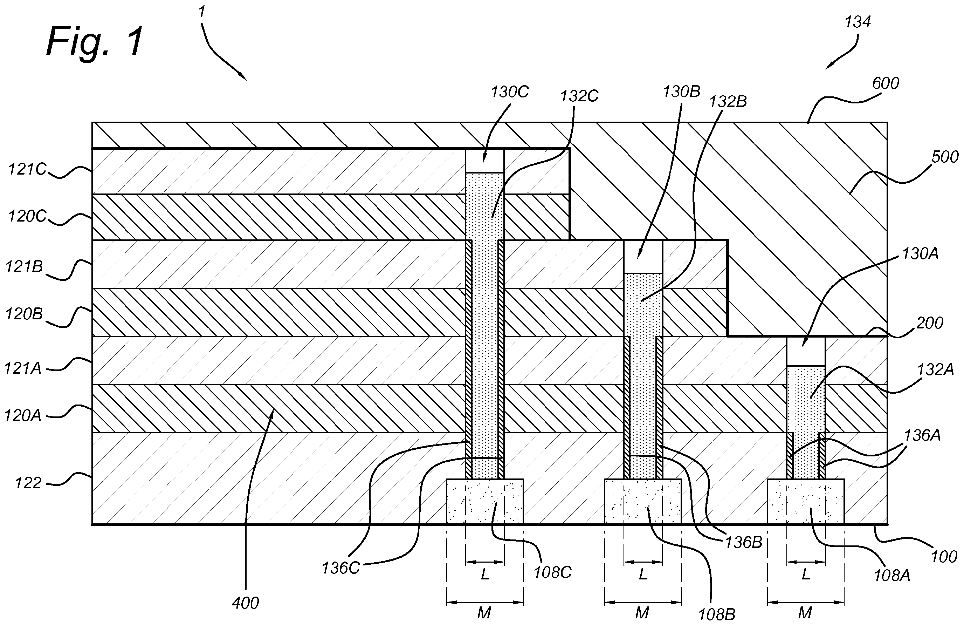

Fig. 1 shows a multilayer device according to the embodiments of the present disclosure, wherein stacked electrically conductive layers 120A, 120B, 120C of different lengths are separated by insulating layers (121A, 121B, 121C) in a contact region 134, forming a staircase 400 configuration. The staircase 400 comprises conductive interconnects 132A, 132B, 132C which connect to a respective conductive layer 120A, 120B, 120C, whereby conductivity is restricted to said respective conductive layer by an insulating liner 136A, 136B, 136C which coats the portion of the conductive interconnects 132A, 132B, 132C exposed to the other conductive layers. A first electrically conductive layer 120A laterally extends past a second conductive layer 120B forming a portion of a stepped surface 200. The second conductive layer 120B laterally extends past a third conductive layer 120C forming another portion of the stepped surface 200. The stepped surface 200 defines a staircase 400 extending between the stepped surface and a bottom layer 122 of the device. A planarization layer 500 extends over the stepped surface 200 and so covers the multilayer device 1. The bottom layer 122 is provided on a semiconductor substrate. The planarization layer 500 comprises a top surface 600. Each conductive interconnect 132A, 132B, 132C has a respective contact opening 130A, 130B, 130C which extends between said respective conductive layers 120A, 120B, 120C and a respective bottom contact 108A, 108B, 108C. The bottom contacts 108A, 108B, 108C are comprised in the bottom layer 122 of the multilayer device 1 at a bottom surface 100 located at the interface between the bottom layer 122 and the semiconductor substrate.

The device 1 advantageously has no electrical contacts extending beyond or within the planarization layer 500. This allows an additional device such as the device 101 detailed below in example 2, with a bottom layer 122' without bottom contacts, to be stacked upon the device 1 to form a stack 111.

### Example 2: Stacked Configuration

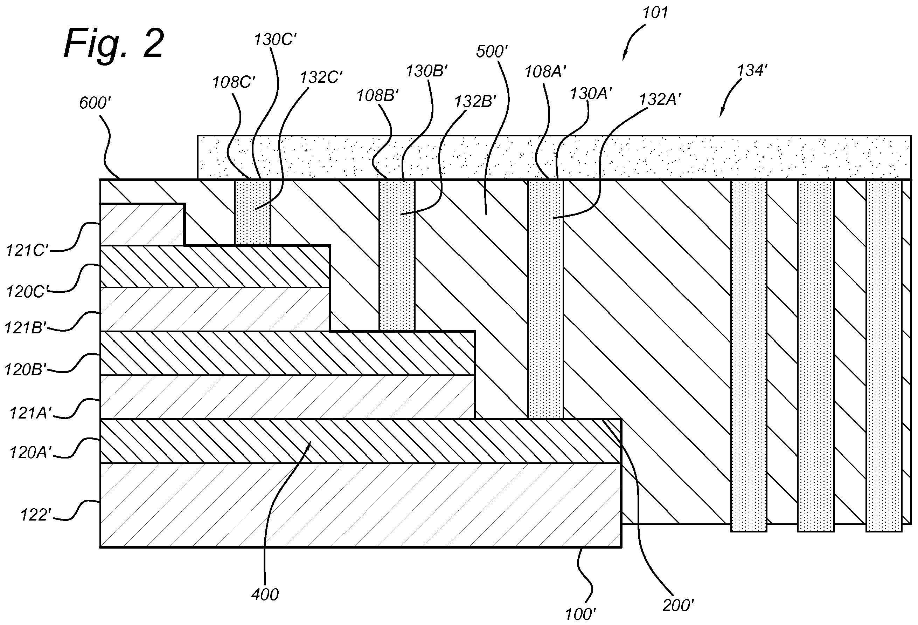

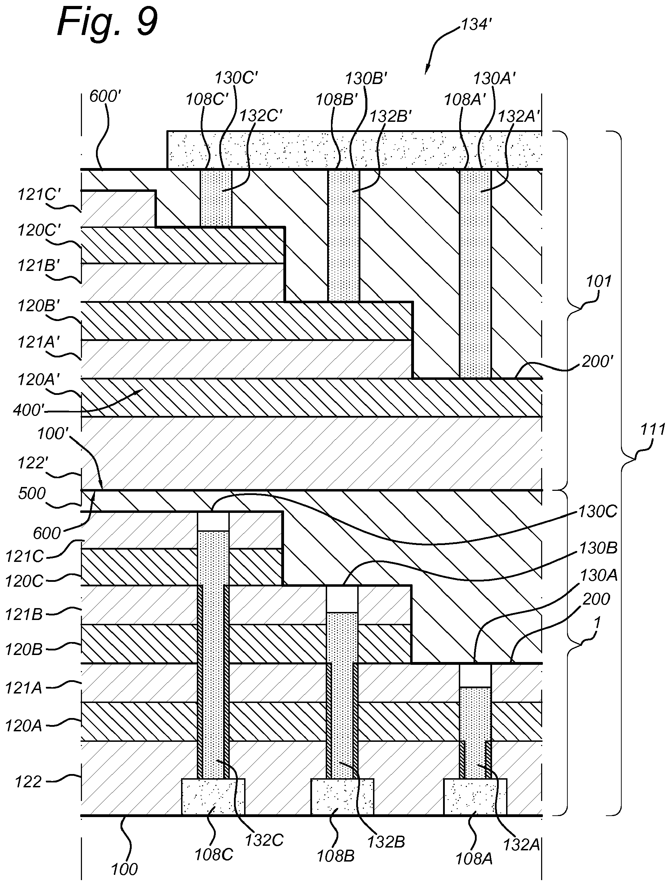

Fig. 2 shows an example of a second multilayer device 101 that can be used in combination with the device 1 of Fig. 1, to form a stack 111 according to embodiments of the present disclosure, as illustrated with Fig. 9. Particularly, this second multilayer device 101, having no bottom contacts in its bottom layer 122', may be advantageously stacked upon the first device 1, which in embodiments according to the present disclosure has no electrical connections running in or through its planarization layer 500. Such a stack allows for a compact, area-saving combination of two devices 1, 101.

The second multilayer device 101 comprises said bottom layer 122' and further comprises a contact region 134'. The contact region 134' comprises a plurality of stacked horizontal layers 120A', 121A', 120B', 121B', 120C', 121C' provided between the bottom layer 122' and the top surface 600', wherein the horizontal layers are substantially parallel to the bottom layer 122', wherein the horizontal layers comprise a plurality of alternating electrically conductive layers 120A', 120B', 120C' and a plurality of electrically insulating layers 121A', 121B', 121C', wherein each respective one of the electrically insulating layers 121A', 121B', 121C' is provided on a respective one of said electrically conductive layers 120A', 120B', 120C', wherein the horizontal layers 120A', 121A', 120B', 121B', 120C', 121C' form a stepped surface 200' in the contact region 134'. The contact region 134' further comprises an electrically insulating planarization layer (500') extending over said stepped surface (200') and comprising said top surface (600'). Within the contact region 134', a first, second and third of said electrically conductive layers 120A', 120B', 120C' are stacked, wherein the first conductive layer 120A' laterally extends past the second conductive layer 120B', forming a stepped surface 200', and the second conductive layer 120B' extends laterally past the third conductive layer 120C'. The different lengths of conductive layers 120A', 120B', 120C' separated by insulating layers form a staircase 400' configuration. The second multilayer device 101 further comprises a planarization layer 500' provided over the horizontal layers 120A', 121A', 120B', 121B', 120C', 121C' and further comprises a top surface 600' comprising a plurality of top contacts 108A', 108B', 108C'. The planarization layer 500' has a first, second and third contact opening 130A', 130B', 130C' which each extend through the planarization layer 500' between respective conductive layers 120A', 120B', 120C' and the respective top contact 108A', 108B', 108C'. Electrically conductive interconnects 132A', 132B', 132C' are provided within the respective contact opening 130A', 130B', 130C' and connect the respective top contact 108A', 108B', 108C' to a respective conductive layer 120A', 120B', 120C'.

As shown on Fig. 9, the second multilayer device 101 may be placed on the multilayer device 1, wherein the bottom surface 100' of the bottom layer 122' of the second multilayer device 101 may be in contact with the top surface 600 of the planarization layer 500 of the first multilayer device 1. This contact may, e.g., relate to a permanent attachment, e.g. by gluing and/or may relate to the second multilayer device 101 being formed, layer by layer, on the top surface 600 of the multilayer device 1.

### Example 3: Method

Figs. 3-8 provide an example of a method of making multilayer interconnects. Hereby, Fig. 3A-8A show respective cross-sections, whereas Fig. 3B-8B show corresponding top views, with the wordline critical dimension N corresponding to the interspacing provided between contact openings.

Fig. 3A shows a cross-section of an etching step in the method of forming multilayer interconnects, which comprises providing 910 a multilayer device 1 comprising a contact region 134 wherein a first, second and third electrically conductive layer 120A, 120B, 120C are each covered by a first, second and third insulating layer 121A, 121B, 121C. The electrically conductive layers 120A, 120B, 120C each have an equal width D1 and the insulating layers 121A, 121B, 121C have an equal width D2; the electrically conductive layers 120A, 120B, 120C are alternatingly configured with respective insulating layers 121A, 121B, 121C to form a stepped surface 200. The multilayer device 1 additionally provides a bottom layer 122 comprising a first, second and third bottom contact 108A, 108B, 108C at a bottom surface 100 located at the interface between the bottom layer 122 and the semiconductor substrate. A first, second and third contact opening 130A, 130B, 130C are etched 920 through the conductive layers 120A, 120B, 120C in the contact region 134 down to the respective bottom contacts 108A, 108B, 108C.

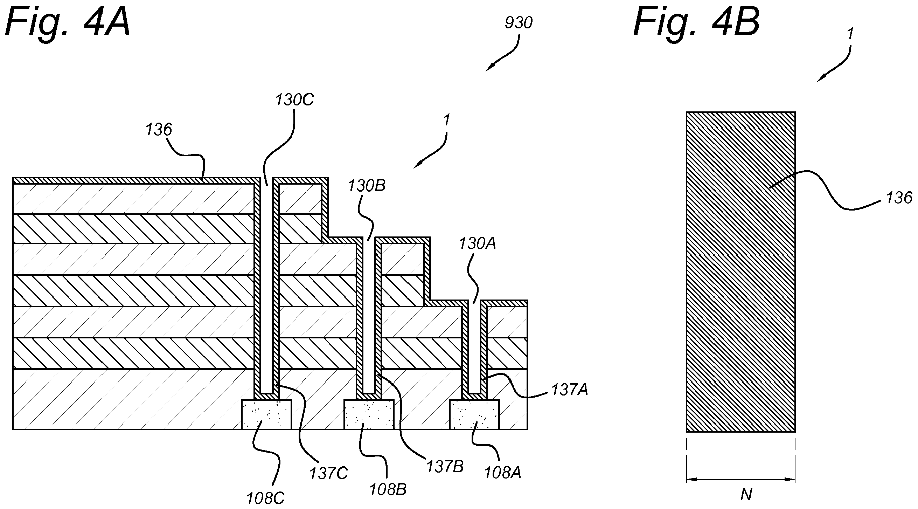

Fig. 4A shows a cross-section in the step of the forming of the interconnects. In this step, an insulating liner 136A, 136B, 136C comprising a dielectric is deposited 930 over a first, second and third sidewall 137A, 137B, 137C of the respective contact openings 130A, 130B, 130C. In embodiments, the liner is a conformal liner deposited along the sidewall of the contact opening, i.e. it is deposited with substantially uniform thickness. This may for example be done using atomic layer deposition. In this step, portions of the insulating liner 136A, 136B, 136C are also deposited 930 over the bottom contacts 108A, 108B, 108C which are of a metal material, as well as over the stepped surface 200. Fig. 4B shows a top-view of the insulating liner 136 in the multilayer device 1.

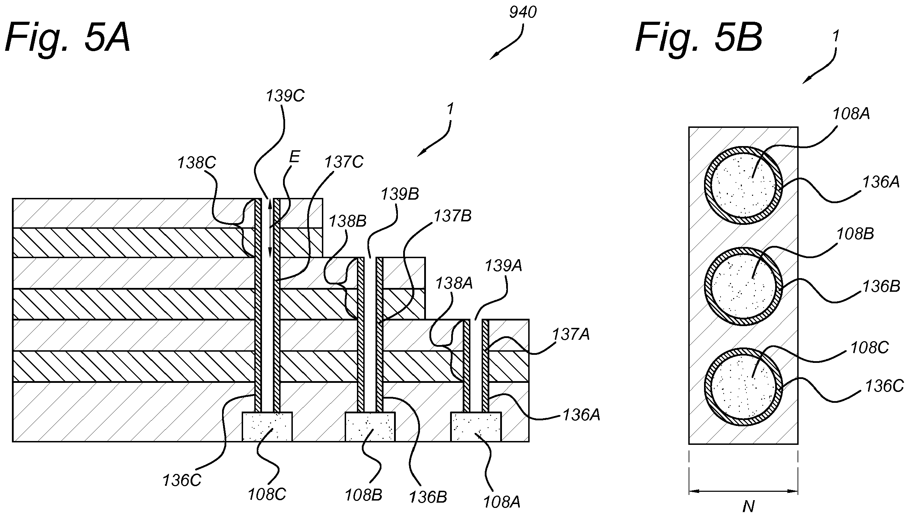

Fig. 5A shows a cross-section of a step in the formation of the multilayer interconnects, wherein an etch chemistry selective on metal is used to remove the liner from the stepped surface 200 and from the bottom contacts 108A, 108B, 108C. This liner etch back step 940 exposes the bottom contacts 108A, 108B, 108C. Fig. 5B shows a top-view of the exposed bottom contacts 108A, 108B, 108C.

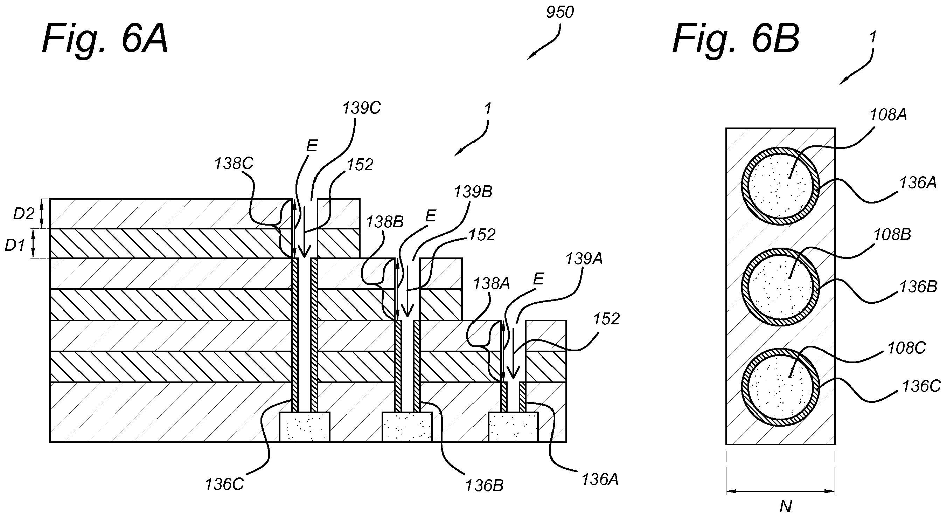

Fig. 6A shows a first, second and third liner top recess 138A, 138B, 138C etching step 950. Etching 950 using dry-etch chemistry is performed with respect to the insulating liner 136A, 136B, 136C, said etching 950 comprising anisotropically etching portions of the insulating liner 136A, 136B, 136C from a distal end 139A, 139B, 139C of the respective contact opening 130A, 130B, 130C towards the respective bottom contacts 108A, 108B, 108C over a depth E. The depth E is essentially equal for the contact openings 130A, 130B, 130C and is not smaller than the combined width of a conductive and insulating layer D1 + D2 and not larger than D1+2*D2, allowing for a margin in the fabrication of the liner top recess 138A, 138B, 138C length. Fig. 6B depicts a top-view of the bottom contacts 108A, 108B, 108C after the liner top recesses 138A, 138B, 138C are etched. Hereby, note that the liner top recesses 138A, 138B, 139C may be realized at once but may also be realized in different subsequent applications of etching chemistry to different portions of the device. The etching 950 of the liner top recesses is preferably performed jointly for at least three contact openings 130A, 130B, 130C contributing to an efficient and cost-effective method of fabrication of the multilayer device 1.

Fig. 7A depicts a metallization step 960 comprising forming a metal fill 132 within the contact openings 130A, 130B, 130C and over a stepped surface 200. Fig. 7B shows a top-view of the metal fill 132 formed within the metallization step 960.

Fig. 8A depicts a metal recess step 970 in the formation of the multilayer interconnects, wherein a wet etch chemistry used to remove the metal fill 132 from the stepped surface 200. Fig. 8B shows a top-view of the formed first, second and third interconnect 132A, 132B, 132C providing electrical contact between the conductive layers 120A, 120B, 120C and a respective one of bottom contacts 108A, 108B, 108C. A planarization layer is formed after the removal of metal fill 132 from the stepped surface 200. This planarization layer is made of an appropriate insulating material and may be viewed as a safeguard during the operation of the multilayer device 1.

## Claims

1. A multilayer device (1), comprising
- an electrically insulating bottom layer (122) provided on a semiconductor substrate;
- a contact region (134) comprising a plurality of stacked horizontal layers (120A, 121A, 120B, 121B, 120C, 121C) provided on the bottom layer (122), wherein the horizontal layers are substantially parallel to a surface of the semiconductor substrate, wherein the horizontal layers comprise a plurality of alternating electrically conductive layers (120A, 120B, 120C) and a plurality of electrically insulating layers (121A, 121B, 121C), wherein each respective one of the electrically insulating layers (121A, 121B, 121C) is provided on a respective one of said electrically conductive layers (120A, 120B, 120C), wherein the horizontal layers (120A, 121A, 120B, 121B, 120C, 121C) form a stepped surface (200) in the contact region (134) defining a staircase (400) extending between said stepped surface (200) and said bottom layer (122);
- a plurality of contact openings (130A, 130B, 130C); and
- a plurality of electrically conductive interconnects (132A, 132B, 132C), wherein each respective one of said interconnects (132A, 132B, 132C) is provided in a respective one of the plurality of contact openings (130A, 130B, 130C), and said each respective one of said interconnects (132A, 132B, 132C) is in electrical contact with a respective one of the electrically conductive layers (120A, 120B, 120C);
**characterized in that said** bottom layer (122) comprises a plurality of bottom contacts (108A, 108B, 108C);
**in that** said each respective one of said contact openings (130A, 130B, 130C) and said each respective one of said interconnects (132A, 132B, 132C) extend within said staircase (400) between the respective one of said electrically conductive layers (120A, 120B, 120C) and a respective one of said bottom contacts (108A, 108B, 108C), and
**in that** said each respective one of said interconnects (132A, 132B, 132C) is insulated from conductive layers (120A, 120B, 120C) below the respective one of said electrically conductive layers (120A, 120B, 120C), wherein said being insulated is preferably realized with an insulating liner (136A, 136B, 136C) comprising a dielectric preferably comprising an oxide, a nitride, or an oxynitride.

2. The multilayer device (1) according to claim 1, wherein each pair of successive electrically conductive layers (120A, 120B) (120B, 120C) of the plurality of electrically conductive layers (120A, 120B, 120C) comprises at least a first conductive layer (120A, 120B) and a second conductive layer (120B, 120C) located higher than the first conductive layer (120A, 102B); wherein the first conductive layer (120A, 120B) comprises a first portion which laterally extends past the second conductive layer (120B, 120C) to form at least a portion of said stepped surface (200); and wherein the respective one of said interconnects (132B, 132C) of the second conductive layer (120B, 120C) has a greater length than the respective interconnect (132A, 132B) of the first conductive layer (120A, 120B).

3. The multilayer device (1) according to claims 1-2, wherein said each respective one of said bottom contacts (108A, 108B, 108C) comprises a bottom contact lateral dimension M larger than an opening lateral dimension L.

4. The multilayer device (1) according to claims 1-3, wherein the device further comprises an electrically insulating planarization layer (500) extending over said stepped surface (200) and comprising a top surface (600) which is preferably essentially planar.

5. The multilayer device (1) according to claims 1-4, wherein the device further comprises a device region comprising at least one semiconductor device connected to at least one of said electrically conductive contacts (132A, 132B, 132C), said at least one semiconductor device comprising at least one of three-dimensional NAND, 3D NAND, storage-class memory, SCM, resistive random access memory, RRAM, phase change random access memory, PC RAM.

6. A system comprising
- the multilayer device (1) according to claim 5;
- a control logic module, preferably a CMOS-comprising control logic module, connected to said at least one semiconductor device;
wherein the control logic module is stacked under said multilayer device (1) in a circuitry under the array configuration, preferably in a CMOS under the array configuration.

7. A stack (111) of a first and a second multilayer device, wherein at least the first multilayer device is the multilayer device (1) according to claims 1-5.

8. Stack (111) according to claim 7, wherein said second multilayer device (101) comprises
- a bottom layer (122');
- a contact region (134') comprising a plurality of stacked horizontal layers (120A', 121A', 120B', 121B', 120C', 121C') provided between the bottom layer (122') and the top surface (600'), wherein the horizontal layers are substantially parallel to the bottom layer, wherein the horizontal layers comprise a plurality of alternating electrically conductive layers (120A', 120B', 120C') and a plurality of electrically insulating layers (121A', 121B', 121C'), wherein each respective one of the electrically insulating layers (121A', 121B', 121C') is provided on a respective one of said electrically conductive layers (120A', 120B', 120C'), wherein the horizontal layers (120A', 121A', 120B', 121B', 120C', 121C') form a stepped surface (200') in the contact region (134');
- an electrically insulating planarization layer (500') extending over said stepped surface (200') and comprising a top surface (600') comprising a plurality of top contacts (108A', 108B', 108C');
- a plurality of contact openings (130A', 130B', 130C') extending within said planarization layer (500') between a respective one of said electrically conductive layers (120A', 120B', 120C') and a respective one of said top contacts (108A', 108B', 108C');
- a plurality of electrically conductive interconnects (132A', 132B', 132C'), wherein each respective one of said interconnects (132A', 132B', 132C') is provided in a respective one of the plurality of contact openings (130A', 130B', 130C'), and said each respective one of said interconnects (132A', 132B', 132C') is in electrical contact with a respective one of the plurality of electrically conductive layers (120A', 120B', 120C').

9. A method of making multilayer interconnects (132A, 132B, 132C) comprising the steps of
- providing (910) a multilayer device (1) comprising
∘ an electrically insulating bottom layer (122) provided on a semiconductor substrate, the bottom layer (122) comprising a plurality of bottom contacts (108A, 108B, 108C);
∘ at least one contact region (134), the contact region (134) comprising a plurality of stacked horizontal layers (120A, 121A, 120B, 121B, 120C, 121C) provided on the bottom layer (122), wherein the horizontal layers are substantially parallel to a surface of the semiconductor substrate, wherein the horizontal layers comprise a plurality of alternating electrically conductive layers (120A, 120B, 120C) and a plurality of electrically insulating layers (121A, 121B, 121C), wherein each respective one of the electrically insulating layers (121A, 121B, 121C) is provided on a respective one of said electrically conductive layers (120A, 120B, 120C), wherein the horizontal layers (120A, 121A, 120B, 121B, 120C, 121C) form a stepped surface (200) in the contact region (134) defining a staircase (400) extending between said stepped surface (200) and said bottom layer (122);
- etching (920) a plurality of contact openings (130A, 130B, 130C) through the plurality of electrically conductive layers (120A, 120B, 120C) in the contact region (134) down to the plurality of bottom contacts (108A, 108B, 108C);
- depositing (930) an insulating liner (136A, 136B, 136C) comprising a dielectric over at least a sidewall (137A, 137B, 137C) of the contact openings (130A, 130B, 130C) extending within said staircase (400);
- etching (950) a liner top recess (138A, 138B, 138C) to the insulating liner (136A, 136B, 136C), said etching (950) comprising, for each respective one of said contact openings (130A, 130B, 130C), anisotropically etching portions of said insulating liner (136A, 136B, 136C) from a distal end (139A, 139B, 139C) of the respective contact opening (130A, 130B, 130C) toward the respective one of said bottom contacts (108A, 108B, 108C) with a first etch chemistry preferably being a dry-etch chemistry, wherein said liner top recess (138A, 138B, 138C) is such that at least the respective one of said electrically conductive layers (120A, 120B, 120C) is exposed; and
- forming (930, 940, 950, 960, 970) a plurality of interconnects (132A, 132B, 132C) within said contact openings (130A, 130B, 130C) for providing an electrical contact between a respective one of the electrically conductive layers (120A, 120B, 120C) and a respective one of the bottom contacts (108A, 108B, 108C) by means of a respective one of said interconnects (132A, 132B, 132C).

10. The method of claim 9, wherein said liner top recess (138A, 138B, 138C) extends from said distal end (139A, 139B, 139C) of the respective contact opening (130A, 130B, 130C) toward the respective one of said bottom contacts (108A, 108B, 108C) over a depth E essentially equal for all contact openings (130A, 130B, 130C), wherein preferably said plurality of electrically conductive layers (120A, 120B, 120C) comprise an essentially uniform thickness D1 and wherein preferably the plurality of electrically insulating layers (121A, 121B, 121C) comprise an essentially uniform thickness D2.

11. The method of claims 9-10, wherein said step of liner top recess etching (950) is performed jointly for at least two contact openings (130A, 130B, 130C), preferably at least three contact openings, more preferably more than three contact openings, wherein preferably said plurality of electrically conductive layers (120A, 120B, 120C) comprise an essentially uniform thickness D1 and wherein preferably the plurality of electrically insulating layers (121A, 121B, 121C) comprise an essentially uniform thickness D2.

12. The method of claims 9-11, wherein a respective one of a plurality of electrically insulating layers (121A, 121B, 121C) is located over the respective one of the electrically conductive layers (120A, 120B, 120C); wherein the plurality of electrically conductive layers (120A, 120B, 120C) comprise an essentially equal thickness D1; wherein the plurality of electrically insulating layers (121A, 121B, 121C) comprise an essentially equal thickness D2; and wherein said depth E is not smaller than D1 + D2 and not larger than D1+2*D2.

13. The method of claims 11-12, wherein said step of depositing (930) the insulating liner (136A, 136B, 136C) further comprises depositing the insulating liner (136A, 136B, 136C) over at least the bottom contacts (108A, 108B, 108C) being metal contacts, and wherein said step of forming (930, 940, 950, 960, 970) the plurality of interconnects (132A, 132B, 132C) comprises a liner etch back step (940) comprising using a second etch chemistry being selective on metal for exposing said bottom contacts (108A, 108B, 108C)

14. The method of claim 13, wherein said liner etch back step (940) preferably precedes said etching (950) step of said liner top recess (138A, 138B, 138C).

15. The method of claims 10-14, wherein said step of forming (930, 940, 950, 960, 970) the plurality of interconnects (132A, 132B, 132C) comprises a metallization step (960) comprising forming a metal fill (132) within said plurality of contact openings (130A, 130B, 130C) and over said stepped surface (200); and a metal recess step (970) comprising using a third etch chemistry preferably being a wet-etch chemistry for removing said metal fill (132) at least from said stepped surface (200).
